# EUROPEAN PATENT APPLICATION

(11) **EP 1 296 386 A2**
(43) Date of publication of application: **26.03.2003**
(21) Application number: 02078698.4
(22) Date of filing: 09.09.2002
(51) Int. Cl.: H01L 51/20

(54) **Sputtered cathode having a heavy alkaline metal halide in an organic light-emitting device structure**

(30) Priority: 19.09.2001 US 956411
(71) Applicant: EASTMAN KODAK COMPANY, Rochester, New York 14650 (US)
(72) Inventor: Madathil, Joseph Kuru, Eastman Kodak Company, Rochester, New York 14650-2201 (US); Raychaudhuri, Pranab Kumar, Eastman Kodak Company, Rochester, New York 14650-2201 (US); Tang, Ching Wan, Eastman Kodak Company, Rochester, New York 14650-2201 (US)
(74) Representative: Parent, Yves

(57) **Abstract**

An OLED device, including a substrate, an anode formed of a conductive material over the substrate, an emissive layer having an electroluminescent material provided over the anode, a buffer layer provided over the emissive layer and containing a halide of a heavy alkaline metal, and a sputtered layer of a metal or metal alloy selected to function with the buffer layer to inject electrons.

## Description

The present invention relates to organic light-emitting diode devices and methods for making such devices, which use an inorganic buffer layer and a sputtered metal or metal alloy layer on such inorganic buffer layer.

Organic electroluminescent (OEL) device, alternately known as organic light-emitting diode (OLED), is useful in flat-panel display applications. This light-emissive device is attractive because it can be designed to produce red, green, and blue colors with high luminance efficiency, operable with a low driving voltage of the order of a few volts and viewable from oblique angles. These unique attributes are derived from a basic OLED structure comprising a multilayer stack of thin films of small-molecule organic materials sandwiched between an anode and a cathode. Tang and others in commonly assigned US-A-4,769,292 and US-A-4,885,211 have disclosed such a structure. The common electroluminescent (EL) medium is comprised of a bilayer structure of a hole-transport layer (HTL) and an electron-transport layer (ETL), typically of the order of a few tens of nanometer (nm) thick for each layer. The anode material is usually an optically transparent indium tin oxide (ITO) film on glass, which also serves as the substrate for the OLED. The cathode is typically a reflective thin film. Selection of electrode materials is based on work functions. ITO is most commonly used as the anode because it has a high work function. Mg:Ag alloys are generally used as electron-injecting contacts because they have lower work functions. Lithium containing alloys such as A1:Li and LiF/A1 contacts also provide efficient electron injection. The device emits visible light in response to a potential difference applied across EL medium. When an electrical potential difference is applied at the electrodes, the injected carriers-hole at the anode and electron at the cathode-migrate towards each other through EL medium and a fraction of them recombine to emit light.

In the fabrication of OLED vapor deposition method is used. Using this method, the organic layers are deposited in thin-film forms onto ITO glass substrates in a vacuum chamber, followed by deposition of the cathode layer. Among the deposition methods for the cathode, vacuum deposition using resistive heating or electron-beam heating has been found to be most suitable because it does not cause damage to the organic layers. However, it would be highly desirable to avoid these methods for fabrication of cathode. This is because these processes are inefficient. In order to realize low cost manufacturing, one must adopt and develop a proven robust high-throughput process specific to OLED fabrication. Sputtering has been used as a method of choice for thin film deposition in many industries. Conformal, dense, and adherent coatings, short cycle time, low maintenance of coating chamber, and efficient use of materials are among few of the benefits of sputtering.

Sputtering is not commonly practiced for fabrication of the OLED cathodes because of the potential damage inflicted on the organic layers and the degradation of device performance Sputter deposition takes place in a high energy and complex environment that is comprised of energetic neutrals, electrons, positive and negative ions, and emissions from the excited states that can degrade the organic layers upon which the cathode is deposited.

Liao and others (Appl. Phys. Lett. 75, 1619 [1999]) investigated using x-ray and ultraviolet photoelectron spectroscopies the damages induced on Alq surfaces by 100 eV Ar ⁺ irradiation. It was revealed from core level electron density curves that some N-A1 and C-O-A1 bonds in Alq molecules were broken. The valance band structure was also tremendously changed implying the formation of a metal-like conducting surface. It was suggested that this would cause nonradiative quenching in OLEDs when electrons are injected into the Alq layer from the cathode and also would result in electrical shorts.

During sputter deposition of cathode, the A1q surface is subjected to high doses of Ar⁺ bombardments at several hundred volts. As shown by Hung and others (J. Appl. Phys. 86, 4607 [1999]), a dose only of 9 × 10¹⁴/cm² altered the valance band structure. Therefore, sputtering a cathode on Alq surface in Ar atmosphere is expected to degrade the device performance.

Sputtering damage is controllable, to some extent, by properly selecting the deposition parameters. European patent applications EP 0 876 086 A2, EP 0 880 305 A1, and EP 0 880 307 A2, Nakaya and others, of TDK Corporation, disclose a method of depositing a cathode by a sputtering technique. After depositing the organic layers, with vacuum still kept, the devices were transferred from the evaporation to a sputtering chamber wherein the cathode layer was deposited directly on the electron-transport layer. The cathode was an A1 alloy comprised of 0.1 - 20 a% Li that additionally contained at least one of Cu, Mg, and Zr in small amounts, and in some cases had a protective overcoat. The OLED devices thus prepared using no buffer layer were claimed to have good adhesion at the organic layer/cathode interface, low drive voltage, high efficiency and exhibited a slower rate of development of dark spot. Grothe and others in Patent Application DE 198 07 370 C1 also disclosed a sputtered cathode of an A1:Li alloy which had relatively high Li content and having one or more additional elements chosen from Mn, Pb, Pd, Si, Sn, Zn, Zr, Cu, and SiC. In all of those examples no buffer was used, yet electroluminescent was produced at lower voltages. Sputtering damage was controlled possibly by employing a low deposition rate. It is easily anticipated that by lowering sputtering power the damage inflicted on the organic layers can be reduced. At low power, however, the deposition rate can be impracticably low and the advantages of sputtering are reduced or even neutralized.

To minimize damage during high speed sputtering of cathodes, a protective coating on the electron-transport layer can be useful. The protective layer, alternately termed as the buffer layer, must be robust to be effective. However, in addition to being resistant to plasma, a buffer layer must not interfere with the operation of the device and must preserve the device performance. Parthasarathy and others (Appl. Phys. Lett. 72,2138 [1998]) reported an application of a buffer layer consisting of copper phthalocyanine (CuPc) and zinc phthalocyanine (ZnPc) during sputtering deposition of a metal free cathode. The buffer layer prevented damage to the underlying organic layers during the sputtering process. Hung and others (J. Appl. Phys. 86, 4607 [1999]) disclosed the application of CuPc buffer layers that permitted high energy deposition of alloy cathodes. The cathode contained a low work function component, Li, which was believed to diffuse through the buffer layer and provided an electron-injecting layer between the electron-transport layer and the buffer layer. Patent Application EP 0 982 783 A2, Nakaya and others, disclosed a cathode of A1:Li alloy. The cathode was prepared by sputtering using a buffer layer constructed of a porphyrin or napthacene compound that was deposed between the electron-transport layer and the cathode. The device containing the sputtered electrode exhibited low drive voltage, high efficiency, and retarded dark spot growth. Although it was stated in all those references that efficient devices were made, none claimed to have eliminated the sputter damage.

Furthermore, the shortcomings of some of the prior art device structures are that they are not ideally suited for full color devices that emit in different colors. While CuPc is largely transparent in the green region of wavelength, the transparencies in the red and blue wavelength regions are substantially lower. To be useful in full color devices, the buffer should have fairly uniform transparency in the entire visible wavelength range. Another undesirable feature is that the organic buffers, such as phthalocyanine layers, are likely to be thick, requiring long deposition time.

It is therefore an object of the present invention to provide a cathode structure in an OLED device, which has relatively uniform response in the visible wavelength range, and provides electron-injection.

Another object of the present invention is to provide a cathode structure for an OLED device that offers significant protection against damage during sputtering deposition of cathode layer.

The above object was achieved in an OLED device, comprising:
a) a substrate;
b) an anode formed of a conductive material over the substrate;
c) an emissive layer having an electroluminescent material provided over the anode layer;
d) a buffer layer, provided over the emissive layer and containing a heavy alkaline metal halide; and
e) a sputtered layer of a metal or metal alloy provided over the buffer layer and selected to function with the buffer layer to inject electrons.

An advantage of the present invention is that damage to organic layers during sputtering is minimized, permitting cathode fabrication at high deposition rates.

Another advantage of the present invention is that the buffer layer/sputtered layer cathode is ideal for full color devices.
FIG. 1 shows schematically the layer structure of the OLED device;
FIG. 2 is a plot of performance of sputtered Mg cathode device vs. RbF buffer thickness;
FIG. 3 is a plot of performance of sputtered Mg cathode device vs. CsF buffer thickness;
FIG. 4 is a plot of performance of sputtered Mg cathode device vs. KF buffer thickness;
FIG. 5 is a plot of performance of sputtered Mg cathode device vs. LiF buffer thickness;
FIG. 6 is a plot of performance of sputtered A1 cathode device vs. CsF buffer thickness; and
FIG. 7 is a plot of performance of sputtered A1 cathode device vs. RbF buffer thickness.

Throughout the ensuring description, acronyms are used to designate the names of different layers and operating features of organic light-emitting diode devices. For reference, they are listed in Table 1.

**Table 1**

| OLED | Organic light-emitting diode |
|---|---|
| ITO | Indium tin oxide |
| HIL | Hole-injection layer |
| HTL | Hole-transport layer |
| EML | Emissive layer |
| ETL | Electron-transport layer |
| NPB | 4,4'-Bis[N-(1-naphthyl)-N-phenylamino]biphenyl (NPB) |
| Alq | Tris(8-hydroxyquinoline) aluminum |
| LiF | Lithium Fluoride |
| CsF | Cesium Fluoride |
| RbF | Rubidium Fluoride |
| KF | Potassium Fluoride |
| Mg | Magnesium |
| Al | Aluminum |

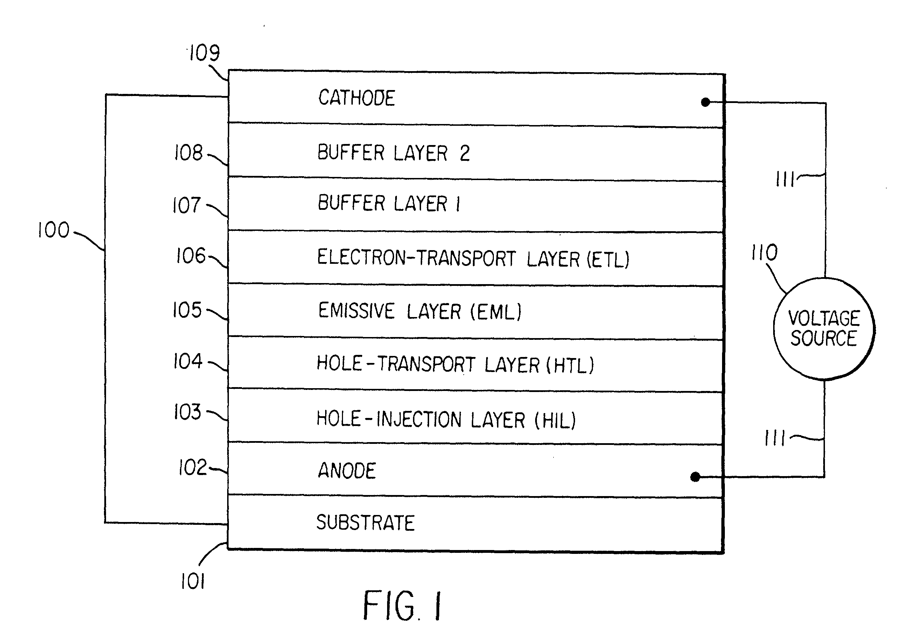

Turning now to FIG. 1, the OLED device 100 of this invention comprises a substrate 101, an anode 102, a hole-injection layer (HIL) 103, a hole-transport layer (HTL) 104, an emissive layer (EML) 105, an electron-transport layer (ETL) 106, a buffer layer 107, and a sputtered cathode 108. In operation, the anode and the cathode are connected to a voltage source 109 via conductors 110 and electrical current is passed through the organic layers, resulting in light emission or electroluminescence from the OLED device. Depending on the optical transparency of the anode and cathode, electroluminescence can be viewed from either the anode side or the cathode side. The intensity of the electroluminescence is dependent on the magnitude of the electrical current that is passed through the OLED device, which in turn is dependent on the luminescent and electrical characteristics of the organic layers as well as the charge-injecting nature of the anode 102 and sputtered cathode 108.

The composition and the function of the various layers constituting the OLED device are described as follows.

Substrate 101 may include glass, ceramic, or plastics. Since the OLED device fabrication does not require high temperature process, any substrate that can withstand process temperatures of the order of 100°C is useful, which includes most thermal plastics. The substrate may take the form of rigid plate, flexible sheet, or curved surfaces. Substrate 101 may include support with electronic backplane, and thus includes active-matrix substrates, which contain electronic addressing and switching elements. Examples of such active-matrix substrates include single-crystal silicon wafer with CMOS circuit elements, substrates with high temperature polysilicon thin-film-transistors, substrates with low temperature polysilicon thin-film-transistors. Those skilled in the art will appreciate that other circuit elements can be used to address and drive the OLED devices.

Anode 102 provides the function of injecting hole into the organic layer when a positive potential relative to the cathode is applied to the OLED. It has been shown, for example, in commonly assigned US-A-4,720,432, that indium tin oxide (ITO) forms efficient anode because it has a relatively high work function. Since ITO film itself is transparent, ITO coated glass provides an excellent support for the fabrication of OLED devices. Other suitable anode materials include high work function metals such as Au, Pt, Pd, or alloys of these metals.

Hole-injection layer (HIL) 103 provides the function of increasing the efficiency of the hole-injection from the anode 102 into the organic layers. It has been shown, for example in commonly assigned US-A-4,885,211, that a porphorinic or phthalocyanine compound is useful as a hole injection layer 103, resulting in increased luminance efficiency and operational stability. Other preferred HIL materials include CFx, which is a fluorinated polymer deposited by plasma-assisted vapor deposition, wherein x is less than or equal to 2 and greater than 0. The method of preparation and the characteristics of CFx have been disclosed in commonly assigned US-A-6,208,077.

Hole-transport layer (HTL) 104 provides the function of transporting holes to the emissive layer (EML) 105. HTL materials include various classes of aromatic amines as disclosed in commonly assigned US-A-4,720,432. A preferred class of HTL materials includes the tetraaryldiamines of formula (I). 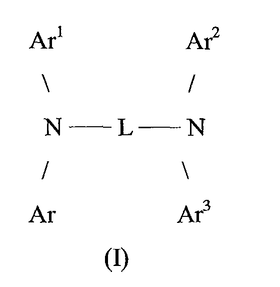 wherein:
Ar, Ar¹, Ar² and Ar³ are independently selected from among phenyl, biphenyl and naphthyl moieties;
L is a divalent naphthylene moiety or dₙ;
d is a phenylene moiety;
n is an integer of from 1 to 4; and
at least one of Ar, Ar¹, Ar² and Ar³ is a naphthyl moiety.

Useful selected (fused aromatic ring containing) aromatic tertiary amines are the following:
4,4'-Bis[N-(1-naphthyl)-N-phenylamino]biphenyl (NPB)
4,4"-Bis[N-(1-naphthyl)-N-phenylamino]-p-terphenyl
4,4'-Bis[N-(2-naphthyl)-N-phenylamino]biphenyl
1,5-Bis[N-(1-naphthyl)-N-phenylamino]naphthalene
4,4'-Bis[N-(2-pyrenyl)-N-phenylamino]bi-phenyl
4,4'-Bis[N-(2-perylenyl)-N-phenylamino]biphenyl
2,6-Bis(di-p-tolylamino)naphthalene
2,6-Bis[di-(1 -naphtyl)amino]naphthalene

Emissive layer 105 of FIG. 1 provides the function of light emission produced as a result of recombination of holes and electrons in this layer. A preferred embodiment of the emissive layer comprises of a host material doped with one or more fluorescent dyes. Using this host-dopant composition, highly efficient OLED devices can be constructed. Simultaneously, the color of the EL devices can be tuned by using fluorescent dyes of different emission wavelengths in a common host material. Tang and others in commonly assigned US-A-4,769,292 has described this dopant scheme in considerable details for OLED devices using Alq as the host material. As set forth in the Tang and others commonly assigned US-A-4,769,292, the emissive layer can contain a green light-emitting doped material, a blue light-emitting doped material, or a red light-emitting doped material.

Preferred host materials include the class of 8-quinolinol metal chelate compounds with the chelating metals being A1, Mg, Li, Zn, for example. Another preferred class of host materials includes anthracene derivatives such as 9,10 dinaphthyl anthracene; 9,10 dianthryl anthracene; and alkyl substituted 9,10 dinaphthyl anthracene, as disclosed in Shi and others commonly assigned US-A-5,935,721.

Dopant materials include most fluorescent and phorphorescent dyes and pigments. Preferred dopant materials include coumarins such as coumarin 6, dicyanomethylenepyrans such as 4-dicyanomethylene-4H pyrans, as disclosed in Tang and others commonly assigned US-A-4,769,292 and in Chen and others in commonly assigned US-A-6,020,078.

Electron-transport layer 106 of FIG. 1 provides the function of delivering electrons injected from the cathode to emissive layer 105 of FIG.1. Useful materials include Alq, benzazoles, as disclosed in commonly assigned Shi and others commonly assigned US-A-5,645,948.

Buffer layer 107 of FIG. 1 provides the function of controlling sputter damage during deposition of the cathode and thereby preserve or enhance the performance of OLED device. It has been found that thin films of materials belonging to the halide groups of alkaline metals are useful in reducing the sputter damage. It has also been determined that fluorides of heavy alkaline metals are particularly effective in minimizing the sputter damage. By heavy alkaline metals it is meant those elements listed in the group 1A of the periodic table that are heavier than lithium. The advantageous results from using a single layered buffer are indeed quite unexpected. Preferred materials for the buffer layer include KF, RbF, and CsF, or combinations thereof.

These buffer layers are transparent in the visible wavelength range. The portion of emitted light that strikes the cathode surface must first pass through the buffer layer. For standard (bottom-emitting) device, the light is reflected back from cathode and directed toward the anode side. For top-emitting device, the light passes through the cathode. In either case, the light emerges with insignificant preferential attenuation of light in the visible wavelength range. These buffer layers are therefore suitable for fabricating full color devices. These groups of materials are sublimable and can be deposited in a thin film form using conventional vapor deposition methods. Since they are electrical insulators, the useful range of thickness for buffer layer using these materials should be in the range of less than 10 nm but greater than 0 nm. The preferred range of thickness is less than 5 nm and greater than 0.5 nm.

Cathode 108 of FIG.1 is typically a fully reflective thin film, several tens of nm thick, and comprised of materials including alloys capable of efficiently injecting electron to the ETL 106 of FIG. 1. For surface emitting devices, the cathode layers can be made substantially transmissive by minimizing its thickness. Mg and Li containing alloys are generally vapor deposited directly on the ETL 106 of FIG. 1 because they have low work functions and make efficient electron-injecting contacts. A bilayer structure, LiF/A1, also provides efficient electron injection to ETL. It has been determined in the present invention that efficient cathodes can also be fabricated by sputtering Mg over a thin buffer layer of halides of heavy alkaline metals that are vapor deposited on the ETL 106 of FIG. 1. Aluminum, a high work function metal, injects electrons very inefficiently when deposited directly on Alq electron-transport layer. It has been found in the present invention that over such buffer layers sputtered A1 functions as efficient electron injecting contacts. The metals other than Mg and A1 may also make efficient electron injecting contact in combination with the buffer, and these can include magnesium, aluminum, silicon, scadium, titanium, chromium, manganese, zinc, yittrium zirconium, hafnium, or metal alloys thereof.

Although the FIG. 1 embodiment is believed preferred, it will be appreciated by those skilled in the art that a device can also be made which does not use hole-injection layer 103, hole-transport layer 104, and electron-transport layer 106. Those skilled in the art will appreciate that the emissive layer can be selected to include hole-transport and electron-transport functions and the anode layer can function as the hole-injection layer. In such an instance, the device requires 105 and does not require layers 103, 104, and 106.

### EXAMPLES

In the following examples, reference should be made to Table 1 for the appropriate structure and operating parameters corresponding to the listed acronym.

The basic organic EL medium consists of a 60 nm Alq emitting and electron-transport (EML/ETL) layer deposited on a 75 nm NPB hole-transport layer (HTL). The NPB and Alq layers were coated in a vacuum coater in single-pump down runs. The samples were then transferred to a multifunction coater where the remaining layers were deposited in proper sequence to generate various device configurations. The multifunction coater was equipped with evaporation boats and crucibles, and sputter guns. Alkaline halides were evaporated from resistively heated boats, and A1 for control device (also termed as standard or standard cathode cell) was evaporated from a crucible by electron beam heating in high vacuum. For sputtering, the deposition chamber was backfilled with pure Ar flowing at 30SCCM to maintain a fixed pressure, typically 16 mT (milli-Torr). The sputtering deposition was carried out by applying DC power to targets of pure Mg or Al. The deposition rate for Mg was 1.2 nm/s at 80 W, and that for A1 was 1.0 nm/s at 100W. It is recognized that deposition rate can easily be controlled by selecting sputtering parameters. Although sputtering from a single target was used, simultaneous sputtering of multiple targets can be employed for increased process throughput. RF, instead of DC, can be used as an alternate power source. It is conceived that instead of a metal layer, an alloy layer with improved properties can be utilized. It is also understood that cosputtering of several targets, instead of sputtering from a single alloy target, can be employed for adjusting the composition of the alloy layer.

The luminance of devices was determined as a function of current using a PR650 radiometer. The drive voltage V (volt) and luminance L (cd/m²) given the tables and plots are those determined when a current corresponding to 20 mA/cm² was passed through the devices.

### Example 1

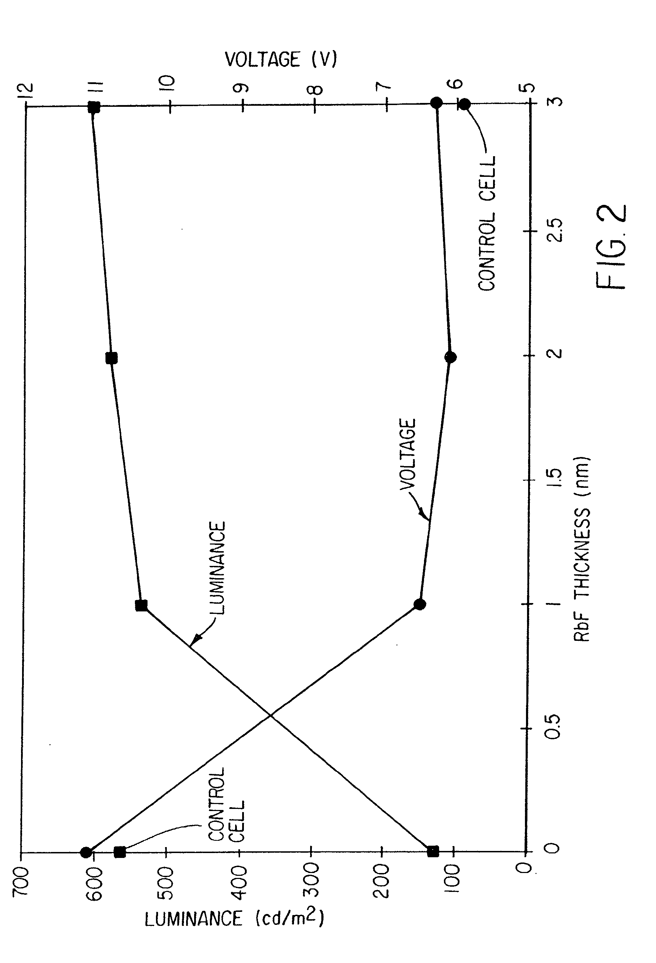

In Table 2 compiled are the device structure and performance of several devices of the present invention including those of a control device. The ITO, HIL, HTL and EML/ETL layers of devices 20 through 24 are identical, and the organic layers were deposited in a single-pump-down run. The control device, 20, which was provided with a standard cathode consisting of a 60 nm thick A1 layer on a 0.5 nm LiF layer, exhibits a luminance of 565 cd/m² and an operating voltage of 5.9 volt. This device is assumed free of damage during cathode deposition. The device 21 has no buffer layer; Mg layer, 60 nm thick, was directly sputtered on the Alq ETL layer. This device exhibits severely degraded performance, as evidenced by its unusually high operating voltage and low efficiency relative to the control device, 20. The degradation is very likely due to damage induced during sputtering of Mg, as thermally evaporated Mg is known to make efficient electron injecting contact to Alq ETL layer. Relative to the control device, 20, the rise in operating voltage and loss in luminance efficiency for the device 21 is 5.2 V and 77%, respectively. The device 22 was provided with a 1 nm thick RbF layer on which a 60 nm thick Mg layer was sputtered under the same conditions as those for the device 21. The device 22 shows a luminance of 538 cd/m² and an operating voltage of 6.5 V indicating markedly improved performance over that of the device 21. This improvement is believed to originate from the protection offered by RbF layer during sputtering deposition of the Mg overlayer. The performance of the device 22, however, falls short of that of the control device 20. In the structure of device 23 incorporated is a 2 nm thick RbF buffer layer. The thicker buffer of device 23 provides better protection against sputter damage and exhibits an improvement over device 22 in operating voltage and luminance. The device 23 has an operating voltage and a luminance efficiency that are virtually identical to those of the standard device 20. Increasing the RbF thickness to 3 nm did not further improve the device performance. The minor discrepancy in performance among devices 20, 23, and 24 is most likely due to variation in device structures and uncertainty of measurements. Thus, RbF buffer, about 2 nm thick, has resulted in elimination or minimization of damage during sputtering deposition of the Mg overlayer. The performance of sputtered devices as a function of RbF buffer thickness along with that of a control device is also shown in FIG. 2. It seen that the optimum RbF buffer thickness is greater than 1 nm and probably less than 3 nm for Mg sputtering.

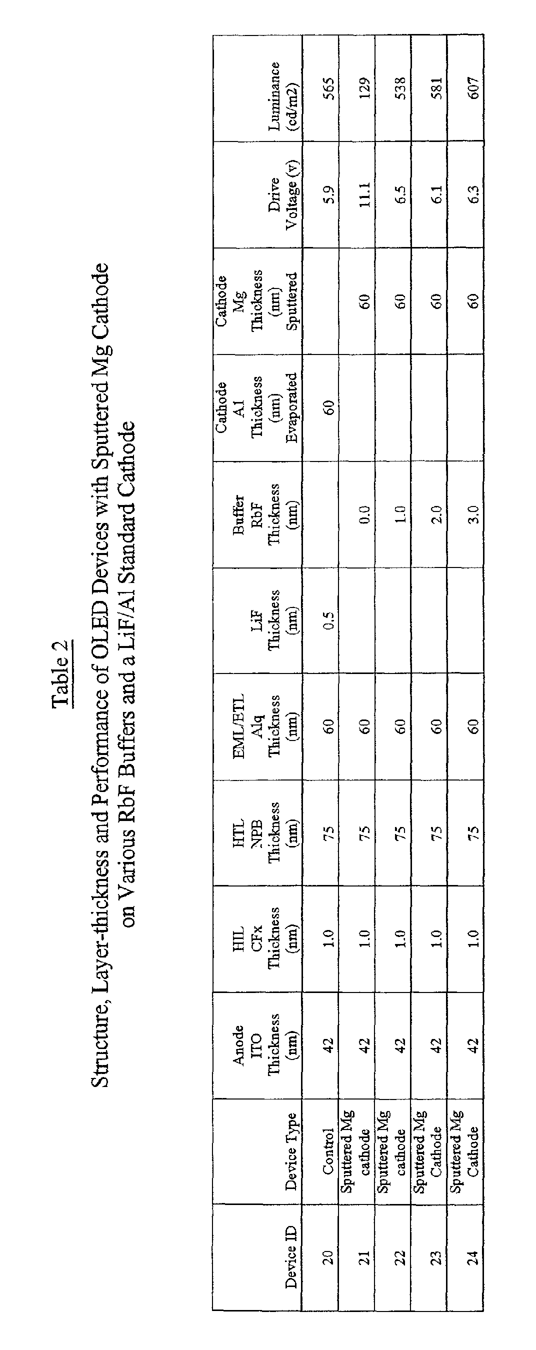

### Example 2

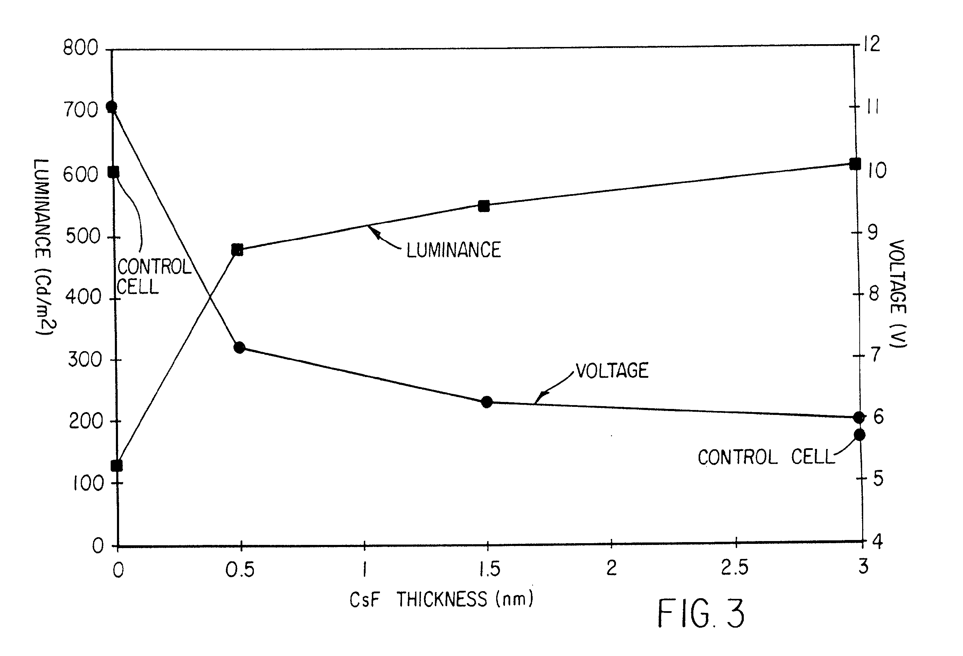

In Table 3 compiled are the device structure and performance of several devices of the present invention including those of a control device. The ITO, HIL, HTL and EML/ETL layers of devices 30 through 34 are identical. The control device, 30, which was provided with a standard cathode consisting of a 60 nm thick A1 layer on a 0.5 nm LiF layer exhibits a luminance of 603 cd/m² and an operating voltage of 5.7 volt. This device is assumed free of damage during cathode deposition. The device 31 has no buffer layer; Mg layer, 60 nm thick, was directly sputtered on the Alq ETL layer. The device data suggest severe sputter damage to EL medium, as evidenced by its unusually high operating voltage and low efficiency relative to the control device 30. The rise in operating voltage and loss in luminance efficiency for the device 31 is 5.4 V and 79%, respectively. The device 32 was provided with a 0.5 nm thick CsF layer on which a 60 nm thick Mg layer was sputtered under the same conditions as those for the device 31. The device 32 shows a luminance of 479 cd/m² and an operating voltage of 7.2 V indicating markedly improved performance over that of the device 31. This improvement is believed to originate from the protection offered by CsF layer during sputtering deposition of the Mg overlayer. The performance of the device 32, however, falls far short of that of the control device 30. In the structure of device 33 incorporated is a 1.5 nm thick CsF buffer layer. The thicker buffer of device 33 provides better protection against sputter damage and exhibits an improvement over device 32 in operating voltage and luminance. The device 33, however, does not have the operating voltage and luminance identical to those of the control device, 30 indicating that sputter damage still persists. Increasing the CsF thickness to 3 nm did further improve the device performance. The performances of the device 34 and control device 30 appear equal. The data suggest that sputter damage in device 34 is virtually eliminated. The minor performance discrepancy between devices 30 and 34 is most likely due to variation in device structure and uncertainty of measurements. Thus, CsF buffer, about 3 nm thick has resulted in elimination or minimization of damage during sputtering deposition of the Mg overlayer. The performance of sputtered devices as a function of CsF buffer thickness along with that of a control device is also shown in FIG. 3. It is seen that the optimum CsF buffer thickness is greater than 1.5 nm and probably around 3 nm for Mg sputtering.

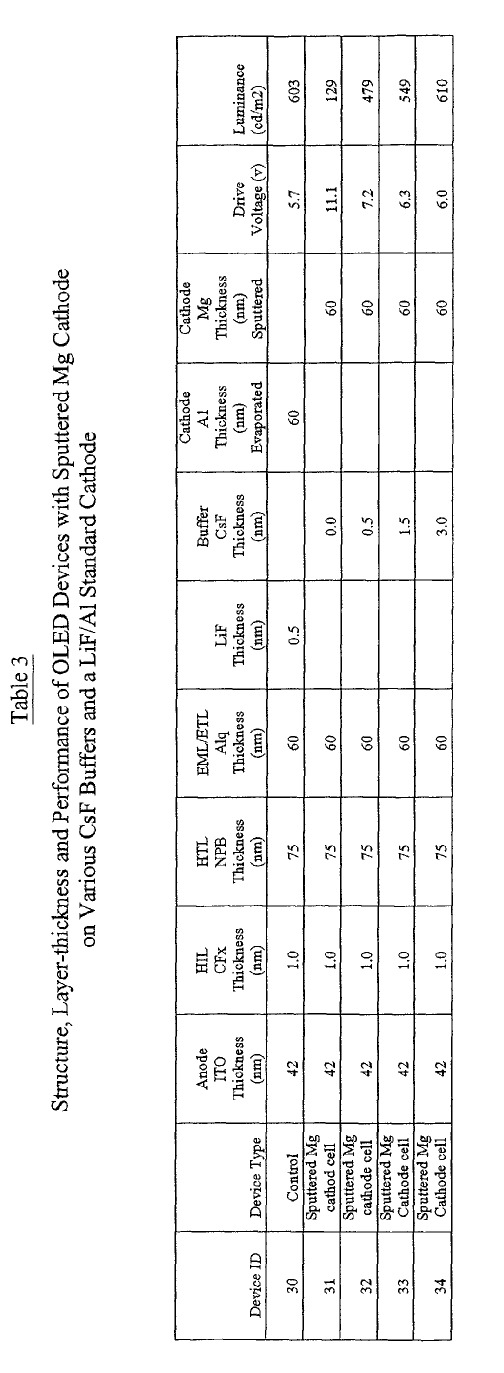

### Example 3

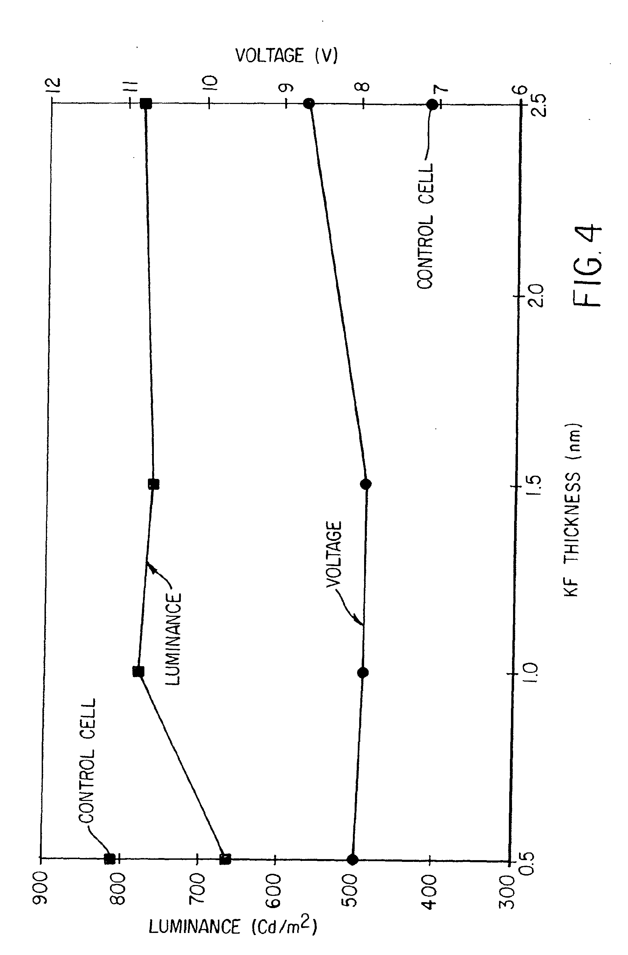

In Table 4 compiled are the device structure and performance of several devices of the present invention including those of a control device. The ITO, HIL, HTL, and EML/ETL layers of devices 40 through 44 are identical, and the organic layers were deposited in a single-pump-down run. The ITO coating in this example is different from those used in devices of Examples 1 and 2. The control device, 40, which was provided with a standard cathode consisting of a 60 nm thick A1 layer on a 0.5 nm LiF layer, exhibits a luminance of 811 cd/m² and an operating voltage of 7.1 volt. This device is assumed free of damage during cathode deposition. The device 41 was provided with a 0.5 nm thick KF layer on which a 60 nm thick Mg layer was sputtered. The device 41 shows a luminance only of 664 cd/m² and an operating voltage of 8.0 V, indicating that 0.5 nm KF buffer offers insufficient protection against sputtering damage to EL medium. The rise in operating voltage and loss in luminance efficiency for the device 41, relative to the control device 40, is 0.9 V and 18%, respectively. Increasing the KF buffer thickness to 1.0 nm results in improvements in luminance efficiency, but beyond that the luminance appears leveled off. However, the voltage appears to increase significantly beyond 1.5 nm. The best-sputtered device in this example, device 42, has over 96% of the luminance of the control device, but the voltage is 0.8 V higher than the control device 40. Thus, KF buffer about 1 nm thick has resulted in minimization of damage during sputtering deposition of the Mg overlayer. The performance of sputtered device as a function of KF buffer thickness along with that of a control device is also shown in FIG. 4. It is seen that the optimum KF buffer thickness is about 1 to 1.5 nm for Mg sputtering.

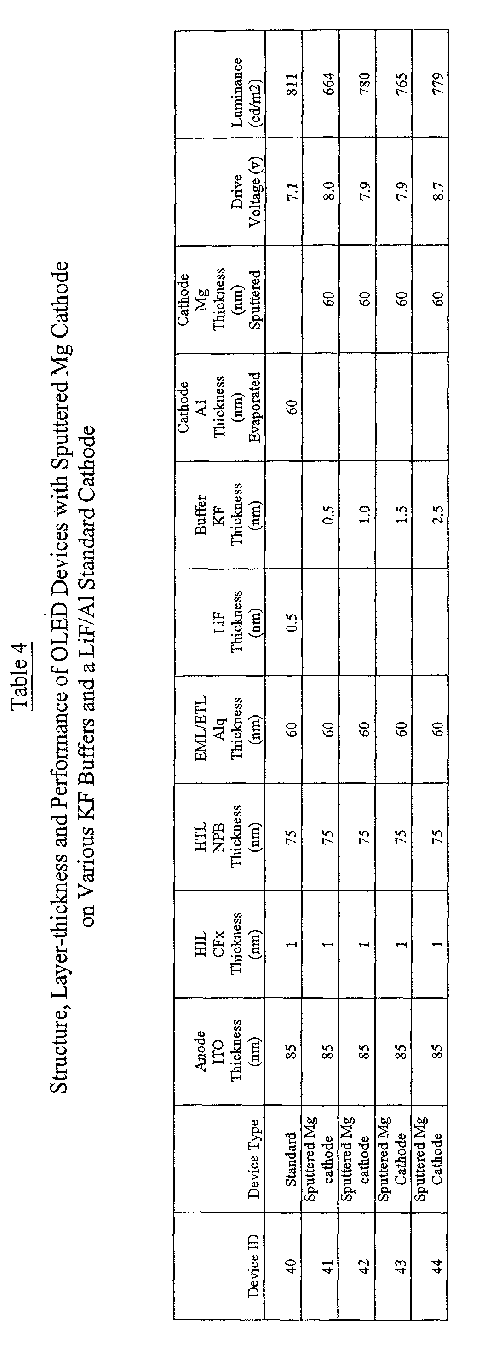

### Example 4

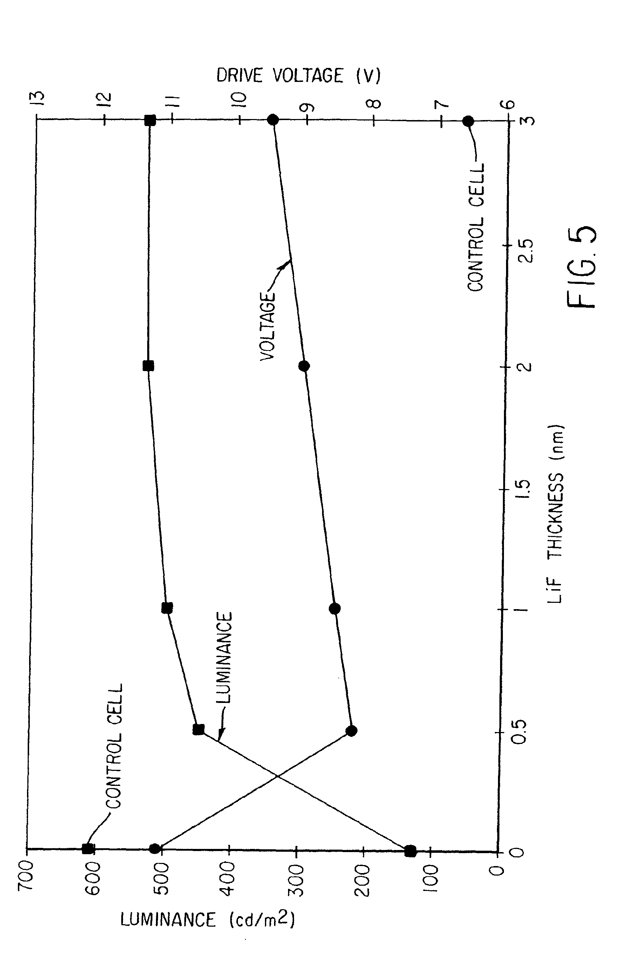

Table 5 includes the device structures and performance of another set of devices having sputtered Mg cathodes on LiF buffers and a control device having a standard cathode. Again the ITO, HIL, HTL, and EML/ETL layers of the devices 50 through 55 are identical. The standard cell, device 50, which was provided with a standard cathode consisting of a 60 nm thick A1 layer on a 0.5 nm LiF layer, exhibits a luminance of 610 cd/m² and an operating voltage of 6.6 volt. The device 51 has no buffer layer; Mg layer, 60 nm thick, was directly sputtered on the Alq ETL layer. The device 51 data suggest severe sputter damage to EL medium as evidenced by its unusually high operating voltage and low efficiency relative to the standard cell, device 50, that is assumed free of damage during cathode deposition. The device 52 was provided with a 0.5 nm thick LiF layer, upon which a 60 nm thick Mg layer was sputtered. The device 52 shows a luminance only of 449 cd/m² and an operating voltage of 8.2 V indicating that 0.5 nm LiF buffer offers insufficient protection against sputtering damage to EL medium. Increasing the LiF buffer thickness to 1.0 nm results in improvement in luminance efficiency, but voltage appears degraded. Further increase in the LiF thickness causes monotonic increase in the operating voltage but the luminance efficiency levels off. The sputtered device having the thickest buffer layer, device 55, has 87% of the luminance of the control device 50, but its operating voltage is about 3 volt higher than that of the control device. The sputtered device having a 0.5 nm buffer layer exhibits the lowest voltage in this series, yet its voltage is 1.5 V higher than that of the control device and has only 73% of the luminance of the control device. The performance of sputtered devices as a function of LiF buffer thicknesses along with that of a control device are also shown in FIGS. It is seen from Tables 2 through 5 and FIGS.2 through 5 that for Mg sputtering LiF as a buffer is less effective than CsF, RbF or KF.

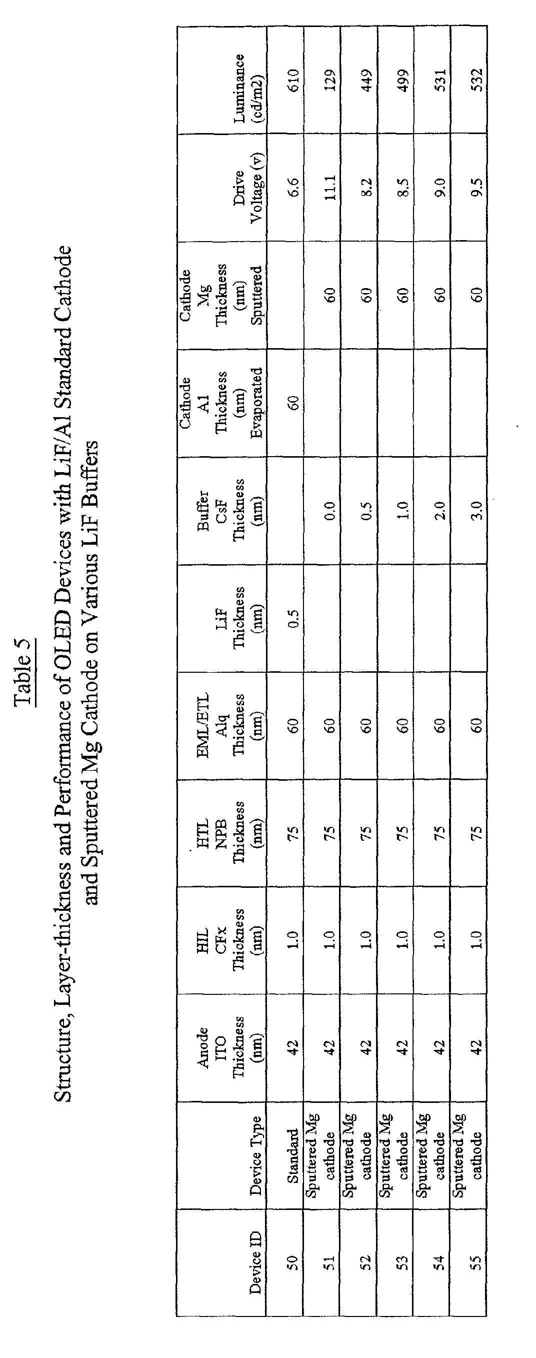

### Example 5

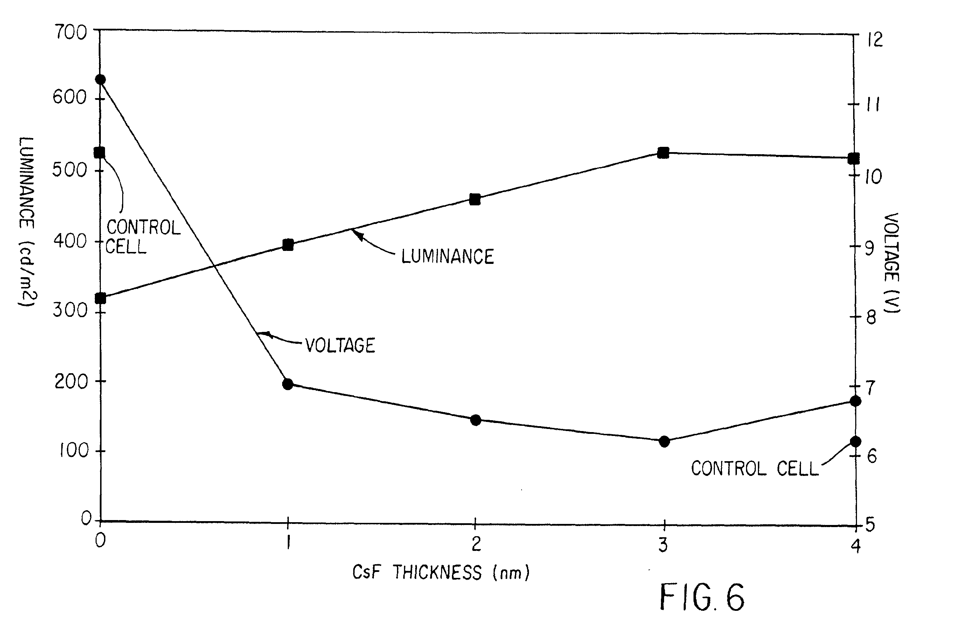

In Table 6 compiled are the device structure and performance of several devices of the present invention including those of a control device. The ITO, HIL, HTL, and EML/ETL layers of devices 60 through 65 are identical. The control device 60, which was provided with a standard cathode consisting of a 60 nm thick A1 layer on a 0.5 nm LiF layer, exhibits a luminance of 526 cd/m² and an operating voltage of 6.2 volt. This device is assumed free of damage during cathode deposition. The device 61 has no buffer layer; A1 layer, 60 nm thick, was directly sputtered on the Alq ETL layer. This device exhibits severely degraded performance, as evidenced by its unusually high operating voltage and low efficiency relative to the control device 60. The degradation is likely due to high work function of A1 but may also have contributions from the sputtering damage. The rise in operating voltage and loss in luminance efficiency for the device 61 is 5.1 V and 39%, respectively. The device 62 was provided with a 1 nm thick CsF layer on which a 60 nm thick A1 layer was sputtered under the same conditions as those for the device 61. The device 62 shows a luminance of 398 cd/m² and an operating voltage of 7.0 V indicating markedly improved performance over that of the device 61. This improvement is believed to originate from the protection offered by CsF layer during sputtering deposition of A1 overlayer. The performance of the device 62, however, falls short of that of the control device 60. In the structure of device 63 incorporated is a 2 nm thick CsF buffer layer. The thicker buffer of device 63 provides better protection against sputter damage and exhibits an improvement over device 62 in operating voltage and luminance. The device 63, however, does not have the operating voltage and luminance identical to those of the control device, 60 indicating that sputter damage still persists. Increasing the CsF thickness to 3 nm (device 64) did further improve the device performance. The performances of the device 64 and control device 60 are identical. The data suggest that sputter damage in device 64 is virtually eliminated. The minor discrepancy in performance among devices 60 and 64 is most likely due to variation in device structures and uncertainty of measurements. Increasing the CsF thickness to 4 nm causes no further increase in luminance efficiency and the operating voltage increases slightly. Thus, CsF buffer, about 3 nm, has resulted in elimination or minimization of damage during sputtering deposition of the A1 overlayer. The performance of sputtered devices as a function of CsF buffer thickness along with that of a control device is also shown in FIG. 6. It seen that the optimum CsF buffer thickness is greater than 3 nm and probably less than 4 nm for A1 sputtering.

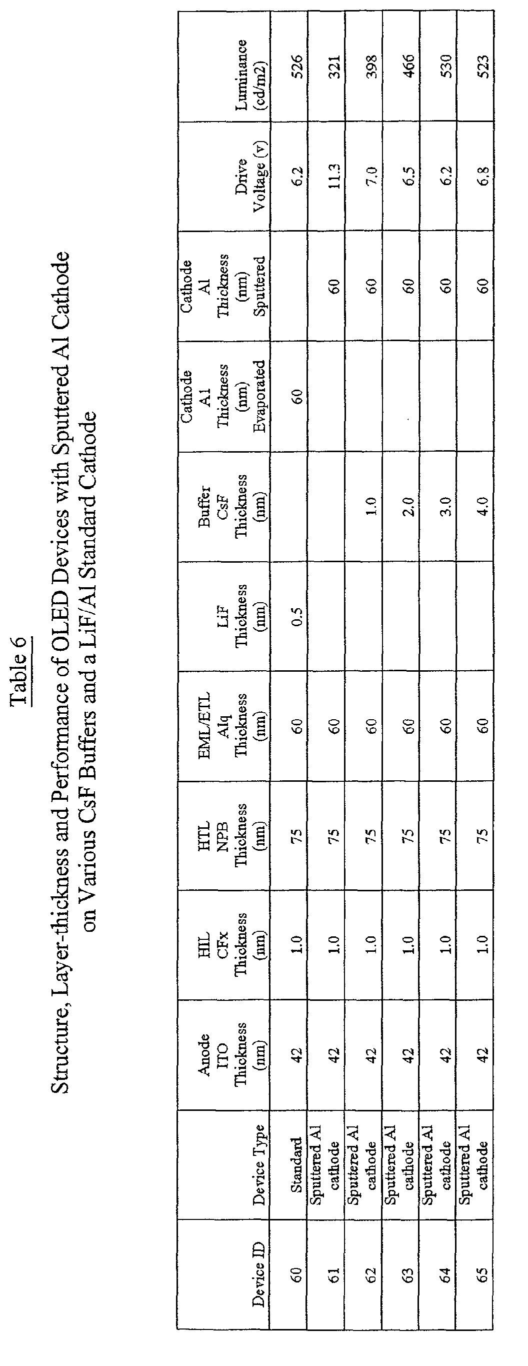

### Example 6

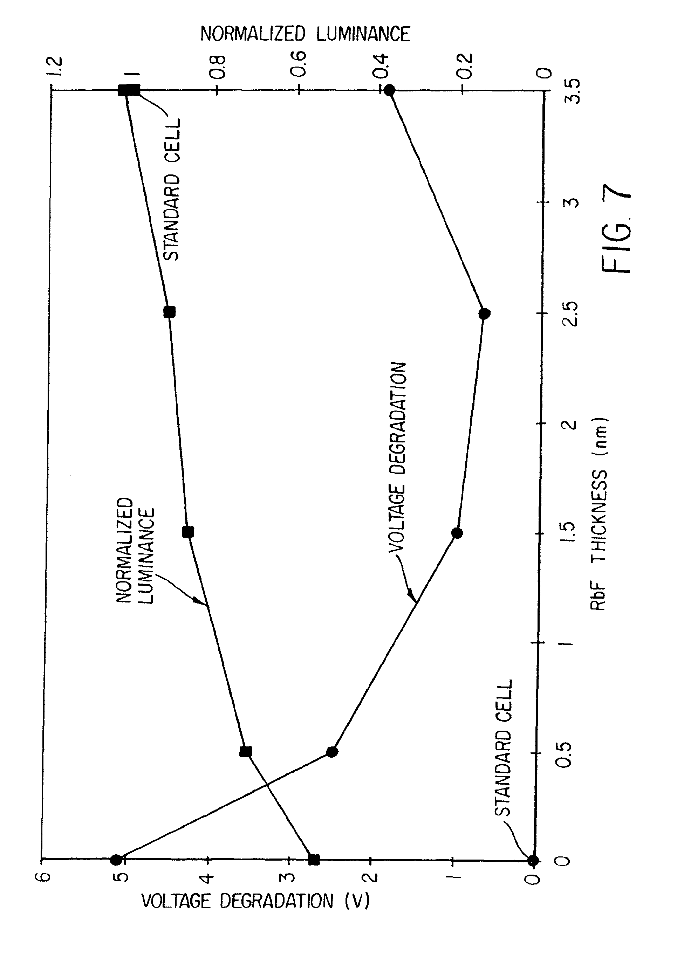

In Table 7 compiled are the device structure and performance of several devices of the present invention including those of a control device. The ITO, HIL, HTL, and EML/ETL layers of devices 70 through 75 are identical, and the organic layers were deposited in a single-pump-down run. In the Table 7 presented is the performance of devices relative to that of the control device 70. The plot in FIG.7 shows the RbF layer thickness dependence of normalized luminance and voltage degradation. The normalized luminance and voltage degradation are defined as follows. If L is the luminance and V is the drive voltage of a device and L_{c} is the luminance and V_{c} is the drive voltage of a control device, then normalized luminance is L/L_{c} and voltage degradation is V- V_{c..} Obviously, for a control cell the normalized luminance is 1 and voltage degradation is 0. The control cell was provided with a standard cathode consisting of a 60 nm thick A1 layer on a 0.5 nm LiF layer. The control device is assumed free of damage during cathode deposition. The device 71 has no buffer layer; A1 layer, 60 nm thick, was directly sputtered on the Alq ETL layer. This device exhibits severely reduced performance, as evidenced by its unusually high voltage degradation and low normalized luminance. The reduced performance is likely due to high work function of A1, but may also have contributions from sputtering damage. The voltage degradation and normalized luminance are 5.1 V and 0.54, respectively. The device 72 was provided with a 0.5 nm thick RbF layer on which a 60 nm thick A1 layer was sputtered under the same conditions as those for the device 71. The device 72 shows a voltage degradation of 2.5 V and normalized luminance of 0.71 indicating markedly improved performance over that of the device 71. This improvement is believed to originate from the protection offered by RbF layer during sputtering deposition of A1 overlayer. The performance of the device 72, however, falls short of that of the control device 70. In the structure of device 73 incorporated is a 1.5 nm thick RbF buffer layer. The thicker buffer of device 73 provides better protection against sputter damage and exhibits an improvement over device 72 in operating voltage and luminance. The device 73, however, does not have the voltage degradation and normalized luminance values identical to those of the control device 70 indicating that sputter damage still persists. Increasing the RbF thickness to 2.5nm (device 74) did further improve the device performance. The performances of the device 74 and control device 70 appear very similar. The data suggest that sputter damage in device 74 is greatly reduced. The minor discrepancy in performance between devices 70 and 74 is most likely due to variation in device structures and uncertainty of measurements. Increasing the RbF thickness to 3.5 nm causes slight increase in luminance efficiency but the operating voltage increases significantly. Thus, RbF buffer, about 2.5 nm has minimized damage during sputtering deposition of the A1 overlayer. It seen from FIG. 7 that the optimum RbF buffer thickness may be around 3 nm for A1 sputtering.

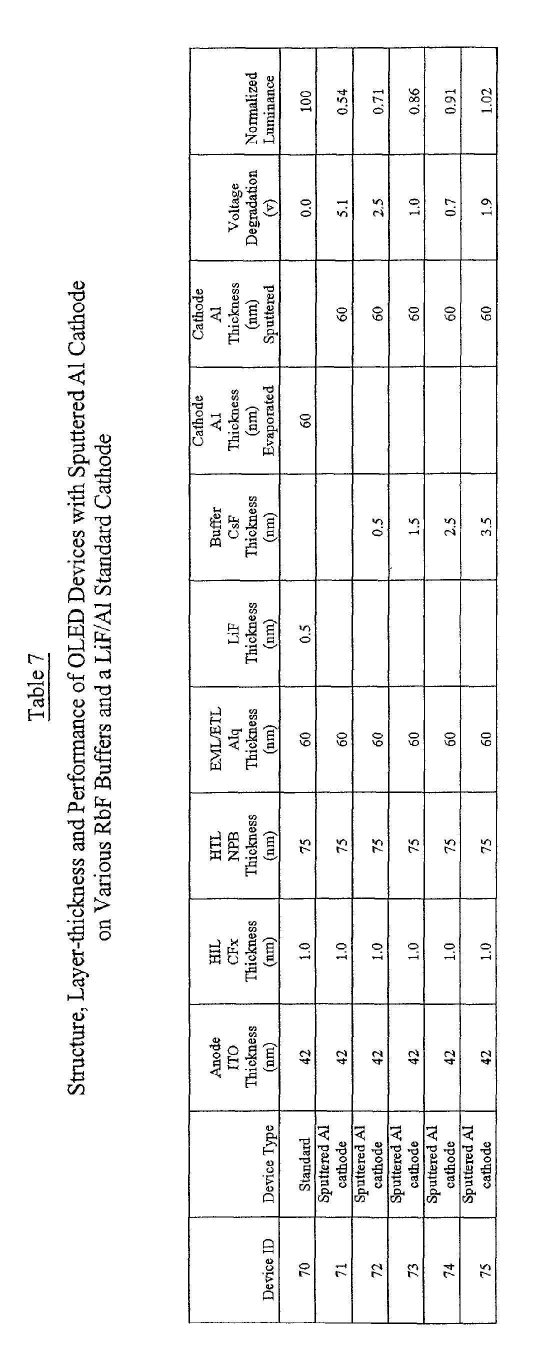

The above examples show that an ultrathin layer comprising a fluoride of an alkaline metal deposited over the Alq electron-transport layer offers significant protection to EL medium during sputtering deposition of A1 and Mg overlayer. In accordance with the present invention, a buffer layer comprising a halide of a heavy alkaline metal can be very effective in protecting organic EL media from damage during sputtering deposition of a cathode overlayer. It is noted that such buffer layer, several nanometer thick, can virtually eliminate sputter damage. The sputtered cathode device can be essentially equal in performance to a control device having an evaporated LiF/A1 cathode.

Other features of the of the invention are included below.

The OLED device wherein the buffer layer has a thickness less than 10 nm but greater than 0 nm.

The OLED device wherein the buffer layer has a thickness less than 5 nm but greater than 0.5 nm.

The OLED device wherein the heavy alkaline halide includes KF, RbF and CsF, or combinations thereof.

The OLED device wherein the metal includes magnesium, aluminum, silicon, scadium, titanium, chromium, manganese, zinc, yittrium, zirconium, hafnium, or metal alloys thereof.

The OLED device wherein the emissive layer includes Alq.

The OLED device wherein the electron-transport layer includes Alq.

The OLED device wherein the emissive layer contains one or more light-emitting doped materials.

The method wherein the sputtering is accomplished using either DC or RF power.

The method wherein the sputtering step is accomplished by sputtering materials from one or more targets.

The method wherein the buffer layer has a thickness less than 10 nm but greater than 0 nm.

The method wherein the first buffer layer has a thickness less than 5 nm but greater than 0.5 nm.

## Claims

1. An OLED device, comprising:
a) a substrate;
b) an anode formed of a conductive material over the substrate;
c) an emissive layer having an electroluminescent material provided over the anode layer;
d) a buffer layer, provided over the emissive layer and comprising a heavy alkaline metal halide; and
e) a sputtered layer of a metal or metal alloy provided over the buffer layer and selected to function with the buffer layer to inject electrons.

2. The OLED device of claim 1 wherein the heavy alkaline metal halides include CsF, RbF, KF, or combinations thereof.

3. The OLED device of claim 2 wherein the buffer layer has a thickness less than 10 nm but greater than 0 nm.

4. The OLED device of claim 2 wherein the buffer layer has a thickness less than 5 nm but greater than 0.5 nm.

5. The OLED device of claim 1 wherein the metal includes aluminum or magnesium or combinations thereof.

6. The OLED device of claim 1 wherein the metal further includes silicon, scadium, titanium, chromium, manganese, zinc, yittrium, zirconium and hafnium, or metal alloys thereof.

7. The OLED device of claim 1 wherein the emissive layer includes Alq.

8. The OLED device of claim 1 wherein the emissive layer contains one or more light-emitting doped materials.

9. An OLED device, comprising:
a) a substrate;
b) an anode formed of a conductive material over the substrate;
c) a hole-injection layer provided over the anode layer;
d) a hole-transport layer provided over the hole-injection layer;
e) an emissive layer having an electroluminescent material provided over the hole-transport layer;
f) an electron-transport layer provided over the emissive layer;
g) a buffer layer, provided over the electron-transport layer and comprising a heavy alkaline metal halide; and
h) a sputtered layer of a metal or metal alloy provided over the buffer layer and selected to function with the buffer layer to inject electrons.

10. A method of making an OLED device, comprising the steps of:
a) providing a substrate;
b) forming an anode of a conductive material over the substrate;
c) depositing an emissive layer having an electroluminescent material provided over the anode layer;
d) forming a buffer layer, provided over the emissive layer and comprising a heavy alkaline metal halide; and
e) sputtering a metal or metal alloy layer provided over the buffer layer.
